# EUROPEAN PATENT SPECIFICATION

(11) **EP 1 705 493 B1**
(45) Date of publication and mention of the grant of the patent: **12.11.2008**
(21) Application number: 05006242.1
(22) Date of filing: 22.03.2005
(51) Int. Cl.: G01R 31/36, H02J 7/00

(54) **A method and device for battery capacity calculation using shift of measurement range**
Verfahren und Gerät zur Batterieladungsbestimmung mit Messbereichsumschaltung
Méthode et dispositif pour détermination d'état de charge utilisant commutation d'étendue de mesurage

(43) Date of publication of application: 27.09.2006
(73) Proprietor: TELEFONAKTIEBOLAGET LM ERICSSON (publ), 164 83 Stockholm (SE)
(72) Inventor: Gustafson, Boel, 227 31 Lund (SE); Edholm, Bengt, 224 71 Lund (SE)
(74) Representative: Andersson, Björn E.

(56) References cited:
- US-A- 5 353 026
- US-B1- 6 259 232
- US-B1- 6 646 420

## Description

### Field of the Invention

The present invention relates generally to a method and device for fuel gauge range selection for measuring remaining battery charge of a battery operated electronic apparatus, having a sigma delta modulator generating a bit stream corresponding to the current consumed by the apparatus.

### Description of the Prior Art

Users of portable electronic apparatuses demand for a reliable and precise amount of battery time or capacity remaining in their portable electronic apparatuses, for example mobile phones. More particularly, users require accurate information about how much operating or standby time remains or how much time does it take to charge the battery. This becomes an even more technical challenge by the introduction of LiIon/Li polymer battery technology with only a weak correlation between battery cell voltage and remaining battery charge. According to a prior art method of determining the remaining battery time or capacity implies to prepare a look-up table with premeasured current consumption of all phone modes. The activity in the portable apparatus is then mapped to an estimated current consumption stored in the look-up table with a number entries for different look-up modes, in some cases as much as hundreds of different modes. The estimated current consumption is reduced from the remaining battery capacity resulting in a new value of the remaining battery time.

State of the art portable electronic apparatuses, such as mobile phones, operates in a great number of look-up modes as mentioned above, for example different active modes when the apparatus is transmitting information via a wireless or wired communication link or a standby mode when the apparatus is not transmitting. However, it becomes more and more common with portable apparatuses providing more or less complex software components. These software components give rise to more or less processor activity and thus different amount of current consumption in the apparatus. A look-up table implementation including estimated current consumption for all the different activities, including the software components, involves tedious work of creating the look-up table.

According to a prior art hardware fuel gauge for mobile phones, a two-range current measuring device is used. A reason for this is that the dynamic range required in a mobile phone application ranges from about 1 mA (stand-by mode) to about 2 A (transceiving mode). The large dynamic range in combination with required accuracy would imply a costly solution if the whole dynamic range would be covered by one measure range.

The hardware fuel gauge works at a constant measurement range by integrating the voltage over a small sense resistor connected in series with the battery. The voltage is converted into a charge on a capacitance, which forms part of a sigma delta integrator. The charge will then result in a bit stream from the sigma delta integrator representing the current consumed by the mobile phone. The bit stream from an ideal sigma delta integrator with zero current flowing through the sense resistor would for example consist of "1s" and "-1s", i.e (1,-1,1,-1,1,-1 ...) summing up to zero. When the maximal possible current of the specific range is reached, the bit stream will for example consist of only 1s, i.e (1, 1, 1, 1, 1...). Alternatively, the bit stream can consist of 1 and 0. Maximum current in one direction would be only "1"s, zero current alternation 1, 0, 1, 0 and max current in the other direction only 0, 0, 0 ....

The bit stream needs to be integrated in order to find out the net charge or discharge of the battery. Typically this is done by feeding the bit stream to an up/down counter that will integrate the bit stream and provide an estimate of remaining the battery charge.

Also the fuel gauge device and its circuits consume current, which is especially critical when the mobile phone is in stand-by mode. Low current consumption is achieved by using the real time clock of for example 32kHz, already available in the phone, as the fuel gauge clocking. Thus, no additional oscillator needs to be running. The relatively low frequency also reduces the power consumption of the fuel gauge device.

US-B1-6 646 420 discloses a method of improving the battery charge measurement range in a sigma delta converter associated with portable applications. It is implemented by interruption of the sigma delta modulator measurement process and changing its reference voltage and measurement time to allow an integrated current to occur over a wider dynamic range. A transmit enable signal is used for changing the range of the sigma delta modulator. However, repetitive high current pulses during low current sleep mode are also measured more accurately by dynamically changing the range of the sigma delta modulator. Interrupting the sigma delta modulator measurement, and changing the reference voltage and measurement time allow integrated current to occur over a wider dynamic range.

A problem with this way of selecting measurement range is that it is difficult to provide a hardware strobe that will switch range at the appropriate current level. The system accuracy of the fuel gauge is detoriated by the fact that the hardware strobe is not selecting the appropriate current range. A hardware strobe related to the transmit enable signal as in US-B1-6 646 420 will force the fuel gauge to use the low-current range in situations where the higher range would be more accurate. A hardware strobe coupled to the processor activity only will on the other hand mean that the fuel gauge is forced to use the high-current range in situations where the lower range would be more accurate.

Periodic processor activities imposed by for example the GSM/WCDMA requirements (system ticks) will detoriate the system accuracy even further. The majority of these activities are only consuming a low current that would be easily covered by the low-current range of the fuel gauge, i.e the change of the range is unnecessary.

Increased complexity of the software in mobile phones approaching PDA like devices, and customers finding their own additions to the software solutions, will cause increased difficulties in determining appropriate hardware strobing for the fuel gauge. Moreover, customers can add co-processors supplied from independent regulators, where the co-processors may lack the required hardware strobes.

### Summary of the invention

It is an object of the present invention to provide a method that overcomes the problem and disadvantages set forth above in connection with the prior art.

This object is achieved by a method of fuel gauge range selection for measuring remaining battery charge of a battery operated electronic apparatus by means of a sigma delta modulator that generates a bit stream, corresponding to the current flow in the apparatus. The method is characterised by the steps of: performing a bit pattern recognition of the bit stream for identifying one or more bit patterns of a predetermined limited number of consecutive bits, representing an increased or decreased current flow, and if said bit pattern is recognised, generating a range shift signal.

A more specific object of the invention is to provide a device for working the method. This object is achieved by a fuel gauge device for measuring the current flows of a battery operated electronic apparatus, comprising a sigma delta modulator configured to measure the current flow of a battery and generate a sigma delta bit stream. The fuel gauge device further comprises a fuel gauge range selection device configured to identify one or more bit patterns of a predetermined limited number of consecutive bits of said bit stream, wherein said predetermined limited number of consecutive bits represents an increased or decreased current flow, and to generate a range shift signal depending on said identified bit pattern.

Further aspects of the invention is identified by the accompanying dependent claims.

Since the range shifts are based upon actual current flowing and not upon HW strobe signals with a weak coupling to actual current, the FG (Fuel Gauge) will remain longer in the more accurate low current range thus improving the overall accuracy. An advantage of the invention is that, due to fewer changes to/from a low and a high-current range, it gives a more accurate fuel gauge.

It should be emphasized that the term "comprises/comprising" when used in this specification is taken to specify the presence of stated features, integers, steps or components but does not preclude the presence or addition of one or more other features, integers, steps, components or groups thereof.

### Brief Description of the Drawings

In order to explain the invention in more detail and the advantages and features of the invention, a preferred embodiment will be described in detail below, reference being made to the accompanying drawings, in which:
FIG 1 is block diagram of a mobile phone including a fuel gauge device according to the invention,
FIG 2 is a block diagram illustrating a fuel gauge device according to one embodiment of the present invention, and
FIG 3 is a flow chart of a method of fuel gauge range selection according to one embodiment of the present invention.

### Detailed Description of the Invention

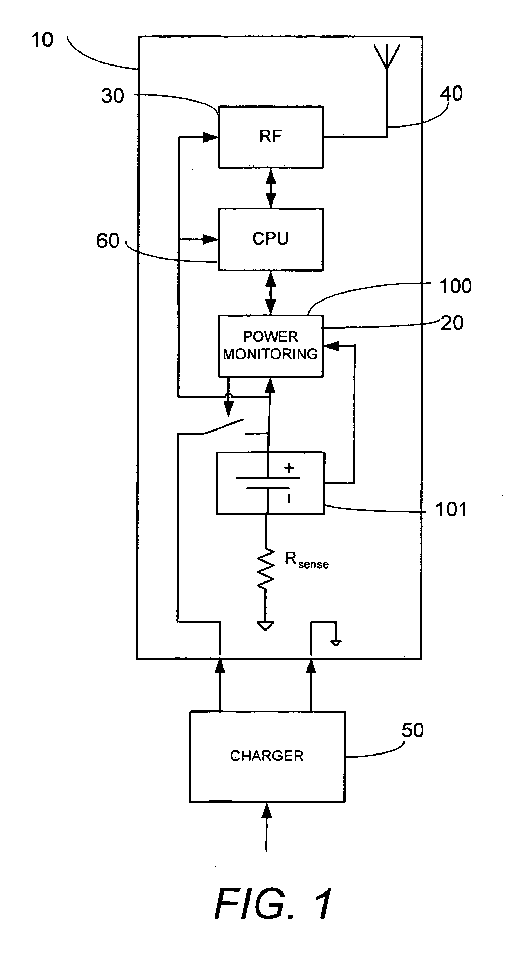

FIG 1 is block diagram of a mobile phone 10 including a fuel gauge device 100 according to the invention. The mobile phone 10 is only one example of an apparatus to which the fuel gauge device 100 is applicable. In addition to the fuel gauge device 100, which form part of a power monitoring device 20, the mobile phone comprises, but is not limited to, an RF (radio frequency) transceiver 30, and an antenna 40 for communication via a communication or network, which can be a mobile communication network. The mobile phone can have a battery 101 for power supply of the different components of the mobile phone 10. The battery 101 can be charged by means of a charger 50. The operation of the phone and its components is controlled by a microcontroller or CPU 60.

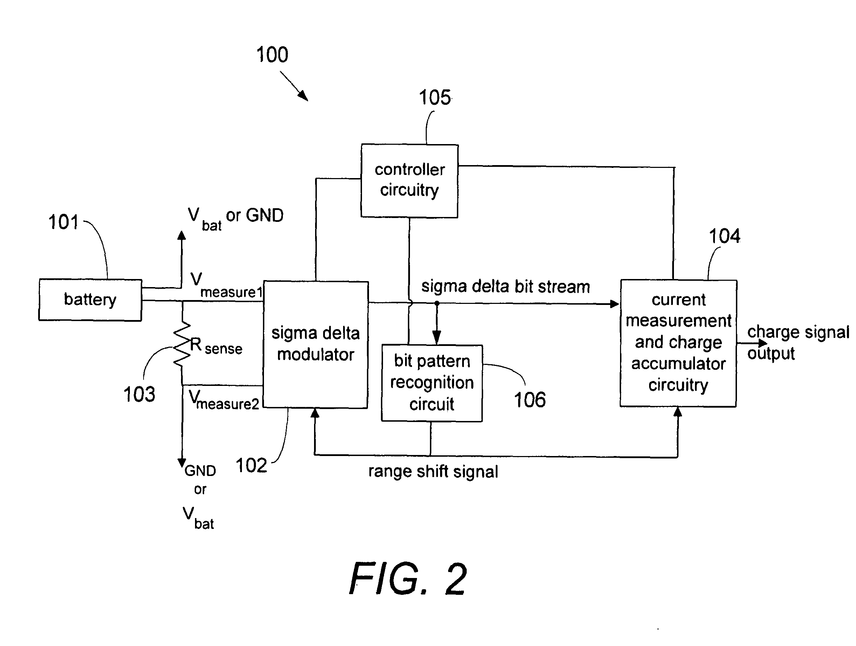

FIG 2 is a block diagram illustrating a fuel gauge device 100 with fuel gauge range selection according to the present invention for measuring the current flows of a battery 101 of a battery operated electronic apparatus, preferably but not limited to portable apparatuses, operating in any one of but is not limited to at least two different modes, a low-current mode and a high-current mode.

The device 100 comprises a sigma delta modulator 102 operatively connected to the terminals of the battery 101. The battery voltage or battery ground is connected to a first input Uₘₑₐₛᵤᵣₑ₁ of the sigma delta modulator 102 and via a resistor Rₛₑₙₛₑ 103 of, but not limited to, for example 25 mohm to a second input Uₘₑₐₛᵤᵣₑ₂ of the sigma delta modulator 102 and to ground (GND) or V_{bat}. The sigma delta modulator measures the current flow and generates a sigma delta bit stream of for example 1s, and -1s depending thereof. A current measurement and charge accumulator circuitry 104 receives the sigma delta bit stream on a first input from an output of the sigma delta modulator 102 for continuously monitoring the current flow. Further, the corresponding charge is withdrawn or added from the battery charge before a present value representing the present battery charge is output from the current measurement and charge accumulator circuitry 104.

The term electronic apparatus includes portable radio communication equipment. The term portable radio communication equipment includes all equipment such as mobile telephones, pagers, communicators, i.e electronic organizers, smartphones, PDAs or the like.

The dynamic range required in a mobile phone application ranges form about 1 mA (stand-by mode) to about 2A (transceiving mode). Therefore, the fuel gauge uses two current measurement ranges, a low-current measurement range and a high-current measurement range, to cover the dynamic range of the mobile phone. The low-current range is preferred when the mobile phone is in stand-by mode with none or low current consuming processor activities and the high-current range is preferred for processor activities consuming a higher current or when the battery is being charged. Although, it is possible to use the high-current measurement range when measuring the current flows during all processor activities of the mobile phone, most of the processor activities are only consuming a low current that can be well covered by the low-current measurement range of the fuel gauge. The latter case makes a switch from the low-current measurement range to the high-current measurement range unnecessary thus maintaining a better accuracy. Moreover, fewer changes from the low to the high-current range and vice versa give smaller error in the fuel gauge.

The appropriate measurement range is selected based on the information present in the sigma delta bit stream directly before the decimation filtering, and the current measurement and charge accumulation. When the maximal possible current of a specific range, for example the low-current measurement range, is reached, the bit stream comprises of for example only 1s, i.e (1,1,1,1 ...). However, already a few number of consecutive 1s in the bit stream is an indication of that the current level is approaching the maximum current level of the specific measurement range and would constitute a suitable level for performing a range shift form the low-current measurement range to the high-current measurement range. For example as few as 3, 4, 5, 6, 7, 8, 9, 10 consecutive 1s in the bit stream from the sigma delta modulator is sufficient for performing a range shift. However, other numbers of consecutive 1s can be used within the scope of the invention. Therefore, the fuel gauge device has an additional device or element for recognising the particular bit pattern, including consecutive 1s.

In a preferred embodiment, the device is a bit pattern recognition circuit 106 for identifying three or another number of consecutive 1s. The bit stream from the output of the sigma delta modulator 102 is supplied to an input of the bit pattern recognition circuit 106, which generates a range shift signal on an output. The range shift signal is supplied to a second input of the current measurement and charge accumulator circuitry 104 and the sigma delta modulator, where it is detected and causes a range shift, from the low-current measurement range to the high-range measurement range in this embodiment.

On the other side, the range shift from the high-current measurement range to the low-current measurement range is less critical. This is performed either after a predetermined delay time from the last range shift from the low-current measurement range to the high-current measurement range only or in combination with a particular recognised bit-pattern, for example a number of consecutive 0s or alternating 1s and -1s summing up to zero or alternating 1s and 0s.

The operation of the fuel gauge device 100 is controlled by controller circuitry 105, including a controller, control logic and switching elements. Hence, the controller circuitry is configured to, but not limited to, control the sigma delta modulator 102, the current measurement and charge accumulator circuitry 104 and the bit pattern recognition circuit 106 to switch between the low-current measurement range and the high-current measurement range for minimizing the measurement error from the time of overflow until the proper range is selected.

Hence, fewer changes from the low to the high-current range and vice versa give smaller error in the fuel gauge.

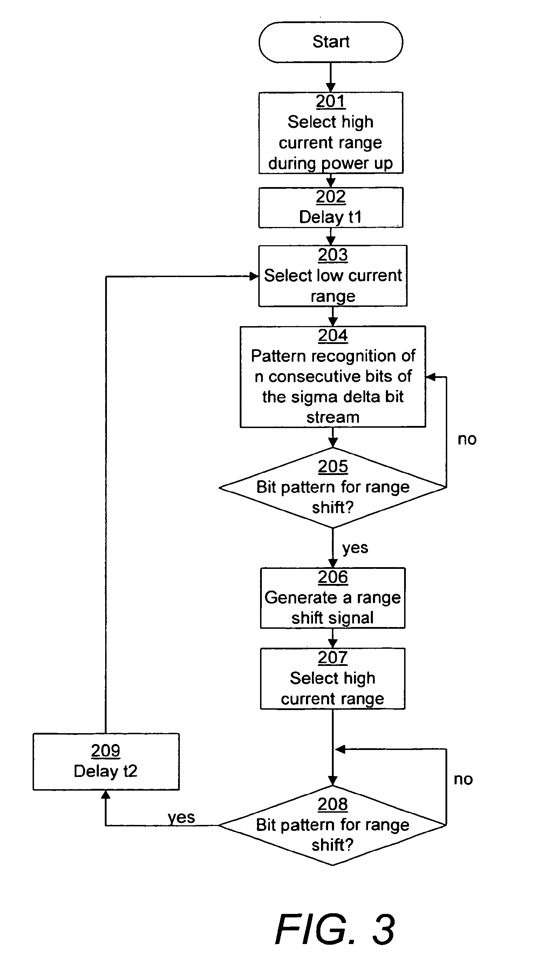

FIG 3. is a flow chart of a method of automatic fuel gauge range selection according to one embodiment of the present invention. The high-current range is preferably selected by the fuel gauge device 100 when the mobile phone is powered up in step 201. After a predetermined delay t1, the fuel gauge device 100 selects the low-current range and starts to perform pattern recognition of the sigma delta modulator bit stream in step 204. At the same time the current measurement and charge accumulator circuitry 104 continuously measures the current flows, withdraws or adds the estimated charge/discharge from the battery charge and generates an output signal representing the present battery charge.

According to this embodiment of the invention, the bit pattern recognition is performed of said bit stream for identifying a predetermined limited number of consecutive bits representing an increased current flow in step 204. A test whether n consecutive 1s or - 1 have been detected is performed in step 205. In this embodiment of the method and device according to the invention n=3. However, as described above in connection with the device n can be an integer, for example 4,5,6,7,8,9, or 10 in other embodiments of the invention. If the test from the bit pattern recognition is negative, i.e no match of 3 consecutive 1s so far, the bit pattern recognition goes on in step 204.

However, if the bit pattern is recognised, i.e the test from the bit pattern recognition turns out positive in step 205, a range shift signal is generated in step 206. Then, the high-current measurement range is selected by the fuel gauge in step 207. The fuel gauge uses the high-current measurement range until the end of a predetermined delay time t2, which is performed in step 208. The delay time is controlled by a timer in this embodiment of the invention. Alternatively, the delay time from the last range shift from the low-current measurement range to the high-current measurement range is combined with a particular recognised bit-pattern before a decision is taken to select the low-current range. It is to be understood that the delay time can be zero in an alternative embodiment of the invention

Although the invention has been described in conjunction with specific embodiments thereof this invention is susceptible of embodiments in different forms, with the understanding that the present disclosure is to be considered as an exemplification of the principles of the invention and is not intended to limit the invention to the specific embodiments illustrated. For example, the bit pattern recognition is performed to detect consecutive 1s in the bit stream according to the embodiment describe herein, but the method and apparatus according to the invention is not limited thereto. The method and apparatus can be configured to detect other bit patterns, that may cause a range shift signal to be generated. An example of another possible bit pattern is consecutive -1s, representing a charging condition of the battery. Hence, the battery charge/discharge can be continuously monitored for estimating the battery charge, withdrawing the estimated discharge from the battery charge, and generating an output signal representing the present battery charge.

## Claims

1. A method of fuel gauge range selection for usage in measuring remaining battery charge of a battery operated electronic apparatus by means of a sigma delta modulator generating a bit stream corresponding to the current flow in the apparatus, **characterised by** the steps of:
performing a bit pattern recognition of said bit stream for identifying one or more bit patterns of a number of consecutive bits representing an increased or a decreased current consumption (204), and
if said bit pattern is recognised, generating a range shift signal (206).

2. A method according to claim 1, comprising the further steps of:
continuously monitoring the current consumption for estimating the battery discharge,
withdrawing the estimated discharge from the battery charge, and
generating an output signal representing the present battery charge.

3. A method according to claim 1 or 2, comprising the further steps of:
continuously monitoring the battery charge/discharge for estimating the battery charge,
withdrawing the estimated discharge from the battery charge, and
generating an output signal representing the present battery charge.

4. A method according to any of the preceding claims, wherein said consecutive bits representing an increased current consumption comprises a number of 1s.

5. A method according to any of the preceding claims, wherein said consecutive bits representing an increased current consumption comprises a number of -1s.

6. A method according to any of the preceding claims, wherein said consecutive bits representing an increased current consumption comprises a number of 0s.

7. A method according to any of the preceding claims, wherein said number is an integer.

8. A method according to any of the claims 1-7, wherein said number is 3, 4, 5, 6, 7, 8, 9, or 10.

9. A method according to any of the preceding claims, comprising the further steps of:
in response to said range shift signal, selecting a high-current measurement range (207), and
using said high-current measurement range.

10. A method according to claim 9, wherein said high-current measurement range is used for a predetermined delay time (208).

11. A method according to claim 9 or 10, comprising the further step of:
performing a bit pattern recognition of said bit stream for identifying a predetermined bit-pattern corresponding to a decreased current flow (208).

12. A method according to claim 11, wherein said consecutive bits representing a decreased current flow comprises a number of 0s or a number of alternating 1s and
- 1s or alternating 1s and 0s, wherein said number is an integer.

13. A method according to claim 10, 11 or 12, comprising the further step of:
selecting a low-current measurement range (203).

14. A method according to any of the preceding claims, comprising the further step of:
selecting the high-current range when the electronic apparatus is powered up (201).

15. A fuel gauge device (100) for measuring the current flows of a battery operated electronic apparatus, comprising a sigma delta modulator (102) configured to measure the current consumption of a battery (101) and generate a sigma delta bit stream, **characterised by** a fuel gauge range selection device (106) configured to identify one or more bit patterns of a number of consecutive bits of said bit stream, said number of consecutive bits representing an increased or decreased current consumption, and to generate a range shift signal depending on said identified bit pattern.

16. A fuel gauge device (100) according to claim 15, wherein the fuel gauge range selection device (106) is a bit pattern recognition circuit.

17. A fuel gauge device (100) according to claim 15 or 16, wherein said fuel gauge range selection device (106) is configured to identify n consecutive 1s of the bit stream representing an increased current consumption, wherein n is an integer.

18. A fuel gauge device (100) according to any of claims 15-17, wherein said fuel gauge range selection device (106) is configured to identify n consecutive -1s of the bit stream representing an increased current consumption, wherein n is an integer.

19. A fuel gauge device (100) according to any of claims 15-17, wherein said fuel gauge range selection device (106) is configured to identify n consecutive 0s of the bit stream representing an increased current consumption, wherein n is an integer.

20. A fuel gauge device (100) according to claim 17, 18 or 19, wherein n=3, 4, 5, 6, 7, 8, 9, or 10.

21. A fuel gauge device (100) according to any of the claims 15 to 20, wherein said fuel gauge range selection device (106) is configured to supply the range shift signal to a sigma delta modulator (102) and to current measurement and charge accumulator circuitry (104) of said fuel gauge device for detection and for causing a range shift.

22. A fuel gauge device (100) according to claim 21, wherein said fuel gauge range selection device (106) is configured to generate a range shift signal representing a range shift from a low-current measurement range to a high-current measurement range.

23. A fuel gauge device (100) according to any of the claims 15-22, wherein said fuel gauge range selection device (106) is configured to identify consecutive bits representing a decreased current flow.

24. A fuel gauge device (100) according to claim 23, wherein said consecutive bits representing a decreased current consumption comprises a number of 0s or a number of alternating 1s and -1s or a number of alternating 1s and 0s.

25. A fuel gauge device (100) according to any of the claims 15-24, wherein said fuel gauge range selection device (106) is configured to generate a range shift signal representing a range shift from a high-current measurement range to a low-current measurement range.

26. A fuel gauge device (100) according to any of the claims 15 to 25, wherein said current measurement and charge accumulator circuitry (104) is configured to continuously monitoring the current flow and withdraw or add the corresponding charge from the present battery charge and generating an output signal representing the present battery charge.

27. A fuel gauge device (100) according to any of the claims 15 to 26, wherein the fuel gauge device (100) is comprised in a mobile phone.

## Patentansprüche

1. Verfahren zum Auswählen eines Brennstoff-Messbereichs zur Verwendung beim Messen eines restlichen Batterieladezustands einer, in einer elektrischen Vorrichtung betrieben Batterie mittels eines Sigma-Delta-Modulators, der einen mit dem Stromfluss in der Vorrichtung zusammenhängenden Bitstrom erzeugt, **gekennzeichnet durch** die Schritte:
Durchführen einer Bitmustererkennung des Bitstromes zum Identifizieren eines oder mehrerer Bitmuster einer Anzahl aufeinanderfolgender Bits, die einem erhöhten oder einem verminderten Stromverbrauch (204) entsprechen, und
wenn das Bitmuster erkannt wird, Erzeugen eines Bereichsänderungssignals (206).

2. Verfahren nach Anspruch 1, ferner die Schritte umfassend:
kontinuierliches Überwachen des gegenwärtigen Verbrauchs zum Schätzen der Batterieentladung,
Abziehen der geschätzten Entladung von dem Batterieladezustand, und
Erzeugen eines Ausgabesignals, das dem gegenwärtigen Batterieladezustand entspricht.

3. Verfahren nach Anspruch 1 oder 2, ferner die Schritte umfassen:
kontinuierliches Überwachen des Batterieladezustandes bzw. der Entladung zum Schätzen des Batterieladezustandes,
Abziehen der geschätzten Entladung von dem Batterieladezustand, und
Erzeugen eines Ausgabesignals, das dem gegenwärtigen Batterieladezustand entspricht.

4. Verfahren nach irgendeinem der vorhergehenden Ansprüche, wobei die aufeinanderfolgender Bits, die einen erhöhten Stromverbrauch entsprechen, eine Zahl von 1en umfasst.

5. Verfahren nach irgendeinem der vorhergehenden Ansprüche, wobei die aufeinanderfolgender Bits, die einen erhöhten Stromverbrauch entsprechen, eine Zahl von -1en umfasst.

6. Verfahren nach irgendeinem der vorhergehenden Ansprüche, wobei die aufeinanderfolgender Bits, die einen erhöhten Stromverbrauch entsprechen, eine Zahl von 0en umfasst.

7. Verfahren nach irgendeinem der vorhergehenden Ansprüche, wobei die Zahl eine ganze Zahl ist.

8. Verfahren nach irgendeinem der Ansprüche 1 - 7, wobei die Zahl 3, 4, 5, 6, 7, 8, 9 oder 10 ist.

9. Verfahren nach irgendeinem der vorhergehenden Ansprüche, ferner die Schritte umfassend:
als Antwort auf das Bereichsänderungssignal, Auswählen eines Hochstrom-Messbereichs (207), und
Verwenden des Hochstroms-Messbereichs.

10. Verfahren nach Anspruch 9, wobei der Hochstroms-Messbereich für eine vorbestimmte Verzögerungszeit (208) verwendet wird.

11. Verfahren nach Anspruch 9 oder 10, ferner den Schritt umfassend:
Durchführen einer Bitmustererkennung des Bitstromes zum Identifizieren eines vorbestimmten Bitmusters, das mit einem verringerten Stromfluss (208) zusammenhängt.

12. Verfahren nach Anspruch 11, wobei die aufeinanderfolgender Bits, die einen verringerten Stromfluss darstellen, eine Zahl von 0en umfassen, oder eine Zahl von alternierend 1en und -1en oder alternierend von 1en und 0en, wobei die Zahl eine ganze Zahl ist.

13. Verfahren nach Anspruch 10, 11 oder 12, ferner den Schritt umfassend:
Auswählen eines Niedrigstrom-Messbereichs (203).

14. Verfahren nach irgendeinem der vorhergehenden Ansprüche, ferner den Schritt umfassend:
Auswählen des Hochstrom-Messbereichs, wenn die elektrische Vorrichtung eingeschaltet wird (201).

15. Brennstoffmessvorrichtung (100) zum Messen des Stromflusses einer Batterie-betriebenen elektronischen Vorrichtung, einen Sigma-Delta-Modulator (102) umfassend, der konfiguriert ist, um den Stromverbrauch einer Batterie (101) zu messen und einen Sigma-Delta-Bitstrom zu erzeugen, **gekennzeichnet durch** eine Brennstoff-Messbereich-Auswahleinrichtung (106), die konfiguriert ist zum Identifizieren eines oder mehrerer Bitmuster einer Anzahl aufeinanderfolgender Bits, wobei die Anzahl aufeinanderfolgender Bits einen erhöhten oder verringerten Stromverbrauch entsprechen, und zum Erzeugen eines Bereichsänderungssignals in Abhängigkeit von dem identifizierten Bitmuster.

16. Brennstoffmessvorrichtung (100) nach Anspruch 15, wobei die Kraftstoff-Anzeigenbereich-Auswahleinrichtung (106) eine Bitmuster-Erkennungsschaltung ist.

17. Brennstoffmessvorrichtung (100) nach Anspruch 15 oder 16, wobei die Brennstoff-Messbereich-Auswahleinrichtung (106) konfiguriert ist, n aufeinanderfolgende 1en des, einen erhöhten Stromverbrauch darstellenden Bitstromes zu identifizieren, wobei n eine ganze Zahl ist.

18. Brennstoffmessvorrichtung (100) nach irgendeinem der Ansprüche 15 - 17, wobei die Brennstoff-Messbereich-Auswahleinrichtung (106), n aufeinanderfolgende -1en des, einen erhöhten Stromverbrauch darstellenden Bitstromes zu identifizieren, wobei n eine ganze Zahl ist.

19. Brennstoffmessvorrichtung (100) nach irgendeinem der Ansprüche 15 - 17, wobei die Brennstoff-Messbereich-Auswahleinrichtung (106), n aufeinanderfolgende 0en des, einen erhöhten Stromverbrauch darstellenden Bitstromes zu identifizieren, wobei n eine ganze Zahl ist.

20. Brennstoffmessvorrichtung (100) nach Anspruch 17, 18 oder 19, wobei n = 3, 4, 5, 6, 7, 8, 9 oder 10.

21. Brennstoffmessvorrichtung (100) nach irgendeinem der Ansprüche 15 - 20, wobei die die Brennstoff-Messbereich-Auswahleinrichtung (106) konfiguriert ist, das Bereichsänderungssignal an einen Sigma-Delta-Modulator (102) und an eine Strommess- und Ladungsakkumulierungsschaltung (104) der Brennstoffmessvorrichtung zur Erfassung und zum Verursachen einer Bereichsänderung zu liefern.

22. Brennstoffmessvorrichtung (100) nach Anspruch 21, wobei die Brennstoff-Messbereich-Auswahleinrichtung (106) konfiguriert ist, ein Bereichsänderungssignal zu erzeugen, das eine Bereichsänderung von einem Niedrigstrom-Messbereich zu einem Hochstrom-Messbereich darstellt.

23. Brennstoffmessvorrichtung (100) nach irgendeinem der Ansprüche 15 - 22, wobei die Brennstoff-Messbereich-Auswahleinrichtung (106) konfiguriert ist, aufeinanderfolgende Bits zu identifizieren, die einen verringerten Stromfluss darstellen.

24. Brennstoffmessvorrichtung (100) nach Anspruch 23, wobei die aufeinanderfolgenden Bits, die einen verringerten Stromfluss darstellen, eine Zahl von 0en oder eine Zahl von alternierend 1en und -1en oder eine Zahl von alternierend 1en und 0en umfassen.

25. Brennstoffmessvorrichtung (100) nach irgendeinem der Ansprüche 15 - 24, wobei die Brennstoff-Messbereich-Auswahleinrichtung (106) konfiguriert ist, ein Bereichsänderungssignal zu erzeugen, das eine Bereichsänderung von einem Hochstrom-Messbereich zu einem Niedrigstrom-Messbereich darstellt.

26. Brennstoffmessvorrichtung (100) nach irgendeinem der Ansprüche 15 - 25, wobei die Strommess- und Ladungsakkumulierungsschaltung (104) konfiguriert ist, den Stromfluss kontinuierlich zu überwachen und die damit zusammenhängende Ladung von dem gegenwärtigen Batterieladezustand abzuziehen oder hinzuzufügen und ein Ausgabesignal zu erzeugen, das den gegenwärtigen Batterieladezustand darstellt.

27. Brennstoffmessvorrichtung (100) nach irgendeinem der Ansprüche 15 - 26, wobei die Brennstoff-Messbereich-Auswahleinrichtung (106) in einem Mobiltelefon enthalten ist.

## Revendications

1. Procédé de sélection d'une plage de jauge à combustible pour une utilisation dans la mesure d'une charge de batterie restante d'un appareil électronique fonctionnant sur batterie au moyen d'un modulateur sigma-delta générant un flux binaire correspondant à la circulation d'un courant dans l'appareil, **caractérisé par** les étapes qui consistent :
à effectuer une reconnaissance de combinaison de bits dudit flux binaire pour identifier une ou plusieurs combinaisons de bits d'un nombre de bits consécutifs représentant une consommation de courant augmentée ou diminuée (204), et
si ladite combinaison de bits est reconnue, à générer un signal (206) de décalage de plage.

2. Procédé selon la revendication 1, comprenant les autres étapes qui consistent :
à contrôler en continu la consommation de courant pour estimer la décharge de la batterie,
à retirer la décharge estimée de la charge de la batterie, et
à générer un signal de sortie représentant la charge présente de la batterie.

3. Procédé selon la revendication 1 ou 2, comprenant les autres étapes qui consistent :
à contrôler en continu la charge/décharge de la batterie pour estimer la charge de la batterie,
à retirer la décharge estimée de la charge de la batterie, et
à générer un signal de sortie représentant la charge présente de la batterie.

4. Procédé selon l'une quelconque des revendications précédentes, dans lequel lesdits bits consécutifs représentant une consommation de courant augmentée comprennent un certain nombre de 1.

5. Procédé selon l'une quelconque des revendications précédentes, dans lequel lesdits bits consécutifs représentant une consommation de courant augmentée comprennent un certain nombre de -1.

6. Procédé selon l'une quelconque des revendications précédentes, dans lequel lesdits bits consécutifs représentant une consommation de courant augmentée comprennent un certain nombre de 0.

7. Procédé selon l'une quelconque des revendications précédentes, dans lequel ledit nombre est un entier.

8. Procédé selon l'une quelconque des revendications 1 à 7, dans lequel ledit nombre est 3, 4, 5, 6, 7, 8, 9 ou 10.

9. Procédé selon l'une quelconque des revendications précédentes, comprenant les autres étapes qui consistent :
en réponse audit signal de décalage de plage, à sélectionner une plage (207) de mesure de courant intense, et
à utiliser ladite plage de mesure de courant intense.

10. Procédé selon la revendication 9, dans lequel ladite plage de mesure de courant intense est utilisée pendant un temps de délai prédéterminé (208).

11. Procédé selon la revendication 9 ou 10, comprenant en outre l'étape qui consisté :
à effectuer une reconnaissance de combinaison de bits dudit flux binaire pour identifier une combinaison de bits prédéterminée correspondant à une circulation de courant diminuée (208) .

12. Procédé selon la revendication 11, dans lequel lesdits bits consécutifs représentant une circulation de courant diminuée comprennent un certain nombre de 0 ou un certain nombre de 1 et de -1 alternant ou de 1 et de 0 alternant, ledit nombre étant un entier.

13. Procédé selon la revendication 10, 11 ou 12, comprenant en outre l'étape qui consisté :
à sélectionner une plage (203) de mesure de courant faible.

14. Procédé selon l'une quelconque des revendications précédentes, comprenant en outre l'étape qui consiste :
à sélectionner la plage de courant intense lorsque l'appareil électronique est mis sous tension (201).

15. Dispositif (100) à jauge de combustible pour mesurer les circulations de courant d'un appareil électronique fonctionnant sur batterie, comportant un modulateur sigma-delta (102) configuré pour mesurer la consommation de courant d'une batterie (101) et pour générer un flux binaire sigma-delta, **caractérisé par** un dispositif (106) de sélection de plage de jauge de combustible configuré pour identifier une ou plusieurs combinaisons de bits d'un certain nombre de bits consécutifs dudit flux binaire, ledit nombre de bits consécutifs représentant une consommation de courant augmentée ou diminuée, et pour générer un signal de décalage de plage suivant ladite combinaison de bits identifiée.

16. Dispositif (100) à jauge de combustible selon la revendication 15, dans lequel le dispositif (106) de sélection de plage de jauge de combustible est un circuit de reconnaissance de combinaison de bits.

17. Dispositif (100) à jauge de combustible selon la revendication 15 ou 16, dans lequel ledit dispositif (106) de sélection de plage de jauge de combustible est configuré pour identifier n 1 consécutifs du flux binaire représentant une consommation de courant augmentée, où n est un entier.

18. Dispositif (100) à jauge de combustible selon l'une quelconque des revendications 15 à 17, dans lequel ledit dispositif (106) de sélection de plage de jauge à combustible est configuré pour identifier n -1 consécutifs du flux binaire représentant une consommation de courant augmentée, où n est un entier.

19. Dispositif (100) à jauge de combustible selon l'une quelconque des revendications 15 à 17, dans lequel ledit dispositif (106) de sélection de plage de jauge de combustible est configuré pour identifier n 0 consécutifs du flux binaire représentant une consommation de courant augmentée, où n est un entier.

20. Dispositif (100) à jauge de combustible selon la revendication 17, 18 ou 19, dans lequel n est égal à 3, 4, 5, 6, 7, 8, 9 ou 10.

21. Dispositif (100) à jauge de combustible selon l'une quelconque des revendications 15 à 20, dans lequel ledit dispositif (106) de sélection de plage de jauge de combustible est configuré pour fournir un signal de décalage de plage à une modulateur sigma-delta (102) et à des circuits (104) de mesure de courant et d'accumulateur de charge dudit dispositif à jauge de combustible pour une détection et pour provoquer un décalage de plage.

22. Dispositif (100) à jauge de combustible selon la revendication 21, dans lequel ledit dispositif (106) de sélection de plage de jauge de combustible est configuré pour générer un signal de décalage de plage représentant un décalage de plage d'une plage de mesure de courant faible à une plage de mesure de courant intense.

23. Dispositif (100) à jauge de combustible selon l'une quelconque des revendications 15 à 22, dans lequel ledit dispositif (106) de sélection de plage de jauge de combustible est configuré pour identifier des bits consécutifs représentant une circulation de courant diminuée.

24. Dispositif (100) à jauge de combustible selon la revendication 23, dans lequel lesdits bits consécutifs représentant une consommation de courant diminuée comprennent un certain nombre de 0 ou un certain nombre de 1 et de -1 alternant, ou un certain nombre de 1 et de 0 alternant.

25. Dispositif (100) à jauge de combustible selon l'une quelconque des revendications 15 à 24, dans lequel ledit dispositif (106) de sélection de plage de jauge de combustible est configuré pour générer un signal de décalage de plage représentant un décalage de plage d'une plage de mesure de courant intense à une plage de mesure de courant faible.

26. Dispositif (100) à jauge de combustible selon l'une quelconque des revendications 15 à 25, dans lequel lesdits circuits (104) de mesure de courant et d'accumulateur de charge sont configurés pour contrôler en continu la circulation de courant et soustraire ou additionner la charge correspondante par rapport à la charge présente de la batterie et pour générer un signal de sortie représentant la charge présente de la batterie.

27. Dispositif (100) à jauge de combustible selon l'une quelconque des revendications 15 à 26, lequel ledit dispositif (100) à jauge de combustible est incorporé dans un téléphone mobile.
